Europäisches Patentamt

European Patent Office

Office européen des brevets

(19)

(11) Numéro de publication: **0 141 741**
**B1**

(12) **FASCICULE DE BREVET EUROPEEN**

(45) Date de publication du fascicule du brevet: **14.12.88**

(51) Int. Cl.⁴: **H 03 C 3/09**

(21) Numéro de dépôt: **84402183.2**

(22) Date de dépôt: **30.10.84**

(54) Emetteur à modulation de fréquence applicable à la radiodiffusion FM.

(30) Priorité: **04.11.83 FR 8317590**

(43) Date de publication de la demande:
**15.05.85 Bulletin 85/20**

(45) Mention de la délivrance du brevet:
**14.12.88 Bulletin 88/50**

(84) Etats contractants désignés:
**AT BE CH DE GB IT LI LU NL SE**

(56) Documents cités:
**DE-A-2 703 566**
**FR-A-2 230 117**
**US-A-3 644 831**
**US-A-4 053 933**

**IEEE JOURNAL OF SOLID-STATE CIRCUITS,
vol. SC-16, no. 4, aou7t 1981, pages 385-392,
IEEE, New York, US; J.W. ARCHER et al.: "A
broad-band UHF mixer exhibiting high image
rejection over a multidecade baseband
frequency range"**

(73) Titulaire: **THOMSON-LGT LABORATOIRE
GENERAL DES TELECOMMUNICATIONS
51, boulevard de la République
F-78400 Chatou (FR)**

(72) Inventeur: **Dominguez, Mariano
THOMSON-CSF SCPI 173, bld Haussmann
F-75379 Paris Cédex 08 (FR)**
Inventeur: **Artaud, Daniel
THOMSON-CSF SCPI 173, bld Haussmann
F-75379 Paris Cédex 08 (FR)**

(74) Mandataire: **Turlèque, Clotilde et al
THOMSON-CSF SCPI 19, avenue de Messine
F-75008 Paris (FR)**

(56) References cited:
**J.E.E., JOURNAL ELECTRONIC ENGINEERING,
no. 144, décembre 1978, pages 40-43, Tokyo,
JP; S. OKANO et al.: "Crystal oscillators
facilitate future frequency control"**

Courier Press, Leamington Spa, England.

## Description

La présente invention concerne les émetteurs en modulation de fréquence, notamment pour la radiodiffusion en modulation de fréquence.

La plupart des émetteurs de radiodiffusion à modulation de fréquence utilisent un oscillateur à la fréquence du canal de sortie, cet oscillateur comportant une diode varicap modulée au rythme du signal de modulation en audiofréquence. Dans les émetteurs modernes, la fréquence centrale est maintenue stable à l'aide d'une boucle à verrouillage de phase comportant un oscillateur de référence à quartz. Dans ce type d'émetteurs, les performances restent limitées en particulier du fait de la caractéristique de bruit: en effet, pour un oscillateur de type LC, à inductance et capacité, le bruit augmente avec la fréquence et le niveau de bruit pour un oscillateur radiofréquence modulé directement ne peut être inférieur à un seuil de l'ordre de — 65 dB par rapport à la porteuse. De plus, un circuit de linéarisation de l'oscillateur est souvent nécessaire pour garder constante l'excursion en fréquence due à la modulation en fonction de la fréquence du canal de sortie. Par ailleurs, la possibilité de modulation de cet oscillateur aux basses fréquences le rend sensible aux effets mécaniques ou microphoniques. En conséquence un isolement efficace aux vibrations est nécessaire.

D'autres systèmes d'émission utilisent une fréquence modulée plus basse, dite fréquence intermédiaire, qui permet de diminuer le bruit. Le signal ainsi modulé est alors multiplié ou transposé en fréquence par mélange pour obtenir le signal à la fréquence d'émission désirée. Ces systèmes ont l'inconvénient de générer des signaux perturbateurs en particulier les fréquences harmoniques ou les produits de battement. Ces signaux sont très gênants car ils peuvent perturber un récepteur accordé sur un autre canal ou perturber d'autres services de radiocommunications. Une réglementation très stricte établit le niveau maximum de tels signaux perturbateurs.

La demande de brevet français n° 77 02522 se rapporte à un dispositif de modulation de fréquence applicable par exemple à la transmission de signaux de modulation dans des canaux séparés de 10 kHz avec des signaux de modulation (bande vocale) de 300 Hz à 3 kHz. Ce dispositif est prévu pour que la modulation soit appliquée à un oscillateur à fréquence fixe proche de la fréquence d'émission, de haute stabilité, les déplacements de fréquence nécessaires pour changer de canal étant fixés par ailleurs par déplacement d'une porteuse à fréquence plus basse (de l'ordre de 2 MHz dans l'exemple) qui commande l'oscillateur de sortie (28) à fréquence variable. Dans ce dispositif, comme indiqué ci-dessus, la fréquence de l'oscillateur à fréquence fixe (48 MHz dans l'exemple) modulé par les signaux de modulation est du même ordre de grandeur que les fréquences d'émission (50 MHz + N × 10 kHz dans l'exemple) des canaux respectifs. Cet oscillateur est un oscillateur à quartz, ce qui ne présente par d'inconvénient puisque la bande de modulation est étroite, et le mélangeur (30) qui reçoit la fréquence de l'oscillateur de sortie (28) et la fréquence modulée est un mélangeur à rejection, suivi d'un filtre passe bande. Il s'agit par exemple de séparer un signal au voisinage de 2 MHz de signal à 48 MHz ou 50 MHz. Le bruit sur le signal issu de l'émetteur reste toujours du même ordre de grandeur puisque la modulation est appliquée à un oscillateur à une fréquence voisine de la fréquence d'émission. Un tel système ne peut absolument pas permettre de diminuer le bruit.

Enfin, l'accroissement de la densité d'émission en modulation de fréquence ainsi que l'utilisation de sources audiofréquences et de récepteurs de très haute fidélité conduit à rechercher indépendamment des problèmes mentionnés ci-dessus, l'amélioration des performances des équipements d'émission.

L'émetteur proposé ci-après permet d'améliorer les performances des équipements de radiodiffusion en modulation de fréquence en évitant les inconvénients d'un émetteur classique mettant en oeuvre une modulation en fréquence intermédiaire, et en diminuant le bruit qui serait obtenu dans un émetteur classique du type à modulation directe à la fréquence d'émission.

Suivant l'invention, un émetteur à modulation de fréquence comportant un oscillateur de sortie centré sur la fréquence centrale $F_s$ du canal d'émission, ayant au moins une entrée de modulation de la fréquence d'émission, commandé par l'intermédiaire d'une boule à verrouillage de phase comportant en série, entre la sortie et l'entrée de modulation de l'oscillateur de sortie, un mélangeur à réjection, dont une première entrée est couplée à la sortie de l'oscillateur et dont une seconde entrée est reliée à la sortie d'un modulateur recevant le signal de modulation, un filtre passe bande, un comparateur de phase analogique dont une entrée est couplée à la sortie du filtre et dont l'autre entrée est couplée à un générateur de fréquence de référence $F_{ol}$ stable égale à la fréquence de battement entre la fréquence moyenne d'émission et la fréquence intermédiaire non atténuée, et un filtre passe bas dont la sortie est couplée à l'entrée de moduation de l'oscillateur, est caractérisé en ce que, pour une radiodiffusion FM de grande qualité, le modulateur est un modulateur en fréquence intermédiaire $F_i$, basse par rapport à la fréquence de l'oscillateur de sortie, comportant un oscillateur commandé par une seconde boucle à verrouillage de phase et modulé par le signal de modulation.

L'invention sera mieux comprise et d'autres caractéristiques apparaîtront à l'aide de la description qui suit en référence aux figures annexées.

la figure 1 est le schéma synoptique d'un premier mode de réalisation de l'émetteur de radiodiffusion à modulation de fréquence suivant l'invention;

la figure 2 est un schéma de détail du modulateur à fréquence intermédiaire utilisé dans l'émetteur suivant l'invention;

la figure 3 est un schéma de détail du mélangeur à réjection utilisé dans cet émetteur;

la figure 4 représente les spectres de certains signaux dans l'émetteur suivant l'invention.

la figure 5 est le schéma synoptique d'un émetteur suivant l'invention avec boucle digitale de positionnement automatique et circuit de maintien en fréquence.

Pour obtenir les avantages résultant de la modulation directe à la fréquence d'émission tout en maintenant le niveau de bruit à une valeur inférieure au niveau admissible, l'émetteur suivant l'invention utilise un oscillateur commandé en tension à la fréquence d'émission associé à une boucle analogique à verrouillage de phase, la modulation étant appliquée non pas directement à l'entrée de commande de l'oscillateur à la fréquence d'émission, mais par l'intermédiaire d'un mélangeur à réjection placé dans la boucle de verrouillage de phase qui reçoit d'une part, une fraction du signal de sortie de l'oscillateur commandé en tension, et d'autre part le signal de sortie d'un modulateur à fréquence intermédiaire.

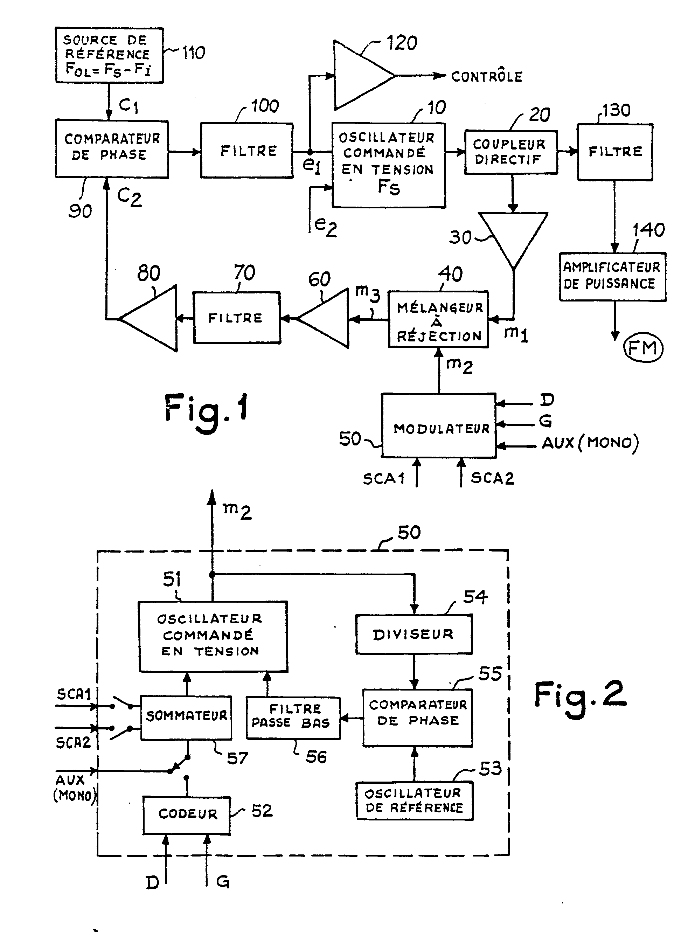

L'émetteur de radiodiffusion à modulation de fréquence selon l'invention est décrit ci-après en référence à la figure 1: l'émetteur comporte un oscillateur 10 commandé en tension, du type LC, comportant une entrée $e_1$ de modulation agissant sur des varicaps, et permettant une modulation sans distorsion d'amplitude ou de phase du signal à la fréquence d'émission par des signaux monophoniques ou stéréophoniques. Cet oscillateur est linéaire dans une large bande. L'oscillateur 10 comporte en outre une entrée $e_2$ de commande en fréquence par varicap également, permettant de changer la fréquence de sortie de l'oscillateur.

Une boucle de verrouillage de phase analogique est associée à cet oscillateur 10: un coupleur directif 20 placé à sa sortie, permet de prélever une partie du signal à sa sortie pour alimenter un amplificateur 30 dont la sortie est reliée à une première entrée $m_1$ d'un mélangeur à réjection de la fréquence image, 40. L'amplificateur 30 joue le rôle d'isolateur pour éviter le retour de fréquences perturbatrices du mélangeur 40 vers l'oscillateur de sortie 10. Le mélangeur a également une seconde entrée, $m_2$, reliée à la sortie d'un modulateur en fréquence intermédiaire, 50. Le modulateur à fréquence intermédiaire 50 comporte deux entrées de modulation, D, G, pour les voies droite et gauche d'un signal stéréophonique, une entrée "AUX" pouvant être attaquée par un signal monophonique ou stérérophonique et deux entrées $SCA_1$ et $SCA_2$ pour la transmission éventuelle d'autres signaux additionnels. Le modulateur à fréquence intermédiaire 50 est du type à modulation directe en fréquence. Il sera décrit ci-après en référence à la figure 2. La sortie du mélangeur à réjection 40 fournit le signal modulé en fréquence résultant du battement ou du mélange du signal à fréquence intermédiaire $F_i$ modulé en fréquence, issu du modulateur 50 et du signal à la fréquence d'émission $F_s$, modulé en fréquence issu de l'oscillateur commandé en tension 10. Ce mélangeur à réjection à la fréquence image a la propriété d'atténuer l'une des fréquences de battement par rapport à l'autre; $F_s + F_i$ est atténuée d'environ 20 décibels par rapport à $F_s - F_i$. Ceci permet d'éliminer la possibilité de verrouillage de l'oscillateur de sortie sur la fréquence de battement non désirée, soit $F_s + F_i$ dans l'exemple indiqué ci-dessus.

La sortie du mélangeur est reliée à l'entrée d'un amplificateur 60 dont la sortie est reliée à un filtre passe-bande 70. La bande passante de ce filtre est déterminée par la plage de variation de la fréquence de battement $F_m = F_s - F_i$, en sortie du mélangeur 40. Cette bande est légèrement supérieure à la largeur de la bande FM, $B_{FM}$, réservée à la modulation de fréquence, ($B_{FM} = 108 - 87,5 = 20,5$ MHz en France). La sortie de ce filtre 70 est reliée à l'entrée d'un amplificateur adaptateur 80 dont la sortie est reliée à une entrée $C_2$ d'un comparateur de phase analogique 90. Ce comparateur est un comparateur à diodes, ayant par ailleurs une autre entrée $C_1$ recevant une fréquence de référence $F_{ol} = F_s - F_i$, fixée par le choix de la fréquence d'émission. Cette fréquence de référence provient d'une source de référence, 110, qui peut être soit un synthétiseur de fréquence, soit un oscillateur à quartz, soit un ensemble d'oscillateurs associés à un synthétiseur et commandés par un système de commutation de façon à sélectionner la fréquence de référence parmi plusieurs, pour chacun des canaux de sortie.

La sortie du comparateur de phase 90 est reliée à l'entrée d'un filtre passe-bas 100 dit "filtre de boucle" dont la sortie est reliée à l'entrée de modulation $e_1$ de l'oscillateur 10. Un amplificateur 120 est prévu en dérivation à la sortie du filtre 100 pour contrôler que le signal est bien présent. Si un des éléments était en défaut, le signal de sortie de cet amplificateur 120 serait perturbé. Enfin, la sortie principale du coupleur 20 est reliée à un filtre 130 suivi d'un amplificateur de puissance 140.

La figure 2 représente en détails le modulateur à fréquence intermédiaire 50. Il comporte un oscillateur commandé en tension 51, à inductance et capacité LC, dont la fréquence est ajustable par l'intermédiaire de varactors. Une entrée de commande de l'oscillateur 51 reçoit le signal de modulation provenant d'un sommateur 57 ayant deux entrées couplées aux entrées $SCA_1$ et $SCA_2$ et une entrée couplée soit à la sortie d'un codeur 52 recevant les signaux stéréophoniques D, G, soit à l'entrée monophonique AUX (MONO). De plus, pour obtenir une stabilité de la fréquence moyenne de l'oscillateur, une boucle à verrouillage de phase utilisant un oscillateur de référence à quartz est prévue. Pour cela, la sortie de l'oscillateur 51 est reliée à l'entrée d'un diviseur 54 qui divise par n, n entier prédéterminé, la fréquence de sortie de l'oscillateur 51. La sortie du diviseur 54 est reliée à la première entrée d'un comparateur de phase 55 qui reçoit sur sa seconde entrée le signal de sortie d'un oscillateur de référence à quartz 53. La sortie du comparateur de phase est reliée à l'entrée d'un filtre passe-bas 56 dont la sortie est reliée à une seconde entrée de commande de l'oscillateur 51. L'oscillateur de référence 53 a une fréquence égale à la fréquence moyenne de l'oscillateur commandé en tension $F_i$ divisée par n, la division par n étant prévue pour réduire l'excursion de phase correspondant à l'excursion de fréquence aux fréquences basses. Ainsi, le modulateur à fréquence intermédiaire 50, travaille autour d'une fréquence $F_i$ fixe, basse, $F_i = 10,7$ MHz par exemple, dont la valeur moyenne est parfaitement stabilisée par la boucle à verrouillage de phase. Du fait que la modulation de fréquence est réalisée directement sur un oscillateur, mais en fréquence intermédiaire, c'est-à-dire à une fréquence plus basse que la fréquence d'émission, le bruit résiduel à un niveau inférieur à celui d'un oscillateur modulé directement à la fréquence de sortie. Par exemple le bruit peut être maintenu dans un tel oscillateur à fréquence intermédiaire à 90 décibels en-dessous du signal utile.

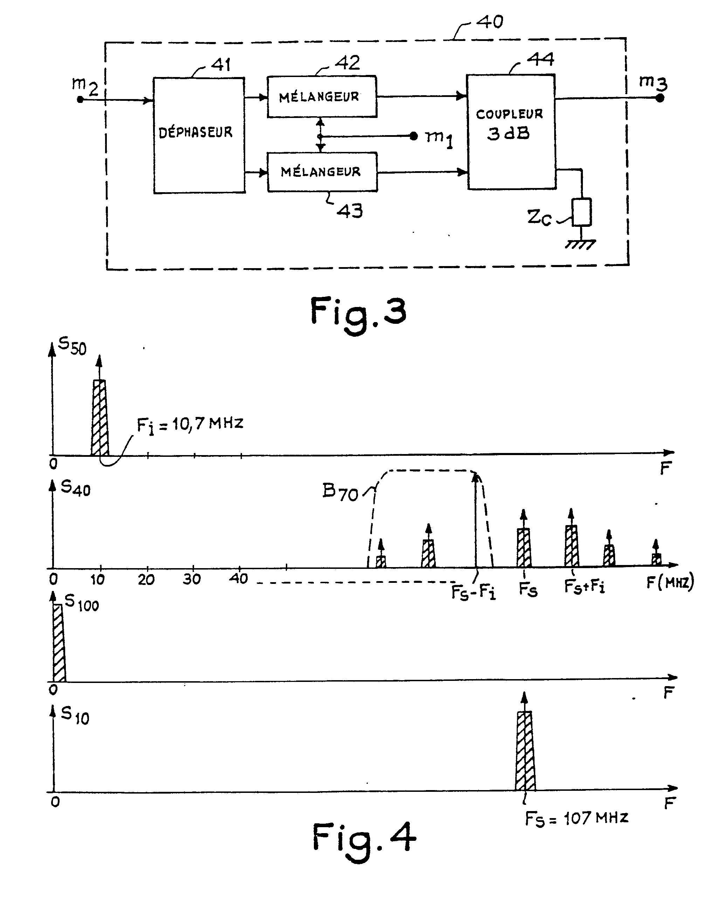

Le mélangeur à réjection de la fréquence image, 40, est représenté en détails sur la figure 3. Il comporte un circuit déphaseur 41 recevant sur son premier accès $m_2$ le signal à fréquence intermédiaire modulé en fréquence par le signal audiofréquence, $S_{50}$, ce signal étant décomposé en deux composantes en quadrature. Les deux sorties du déphaseur 41 sont respectivement reliées aux deux premières entrées de deux mélangeurs 42 et 43 recevant sur leurs deuxièmes entrées le signal à la fréquence d'émission, $S_{30}$, prélevé par le coupleur directif 20 à la sortie de l'oscillateur commandé en tension de la boucle principale 10. Les deux sorties des mélangeurs 42 et 43 sont reliées à deux entrées d'un coupleur 3 dB 44 qui fournit la somme des signaux appliqués sur ses deux entrées à un accès de sortie, $S_{40}$, le quatrième accès étant fermé sur l'impédance caractéristique, $Z_c = 50$ ohms.

La figure 4 qui représente les spectres des signaux en certains points de l'émetteur va permettre de mieux comprendre son fonctionnement. Le signal $S_{50}$ à la sortie du modulateur est le signal à fréquence intermédiaire-modulé par le signal audiofréquence. Son spectre est représenté sur la figure 4. Le signal de sortie de ce modulateur 50 est comme indiqué ci-dessus appliqué à la première entrée d'un mélangeur à réjection de la fréquence image 40, l'autre entrée du mélangeur reçoit le signal de sortie à la fréquence d'émission $F_s$. La fréquence moyenne d'émission peut être, pour un canal donné, éagle à 107 MHz. La sortie $S_{40}$ de ce mélangeur à réjection fournit un signal comportant un certain nombre de raies résultant du mélange de la fréquence $F_i$ et de la fréquence $F_s$, $F_s - F_i$, $F_s$, $F_s + F_i$ etc. . . . , le principe du mélangeur à réjection fait que l'une des fréquences de battement soit $F_s + F_i$ est atténuée par rapport à l'autre, d'environ 20 décibels. Dans l'exemple représenté sur la figure 4 c'est en effet la raie $F_s - F_i$ qui a été

sélectionnée car elle permet de conserver le sens de modulation, et d'utiliser une fréquence de référence plus basse donc de meilleure qualité. Avant le verrouillage de la boucle toutes les raies résultant du mélange de $F_s$ et $F_i$ sont modulées comme le signal $F_i$ appliqué à la première entrée. Après verrouillage, la modulation de la raie $F_s - F_i$ disparait. Le filtre passe bande 70 placé à la sortie du mélangeur à réjection 40 permet de filtrer toutes les raies modulées résultant du mélange et situées en dehors de la bande FM décalée de $-F_i$. Ce filtre 70 apporte une atténuation des fréquences perturbatrices en dehors de sa bande passante de façon à attaquer le comparateur de phase 90 dans les meilleures conditions, évitant ainsi la génération de produits d'intermodulation pouvant se situer dans le bande d'asservissement de la boucle et par conséquent en sortie de l'émetteur. La gabarit $B_{70}$ du filtre 70 a été représenté en pointillés sur la deuxième diagramme de la figure 4, $B_{70} = 74$ à 100 MHz.

La fréquence moyenne d'émission $F_s$ étant déterminée, et la fréquence intermédiaire du modulateur 50 étant fixe, la fréquence de fréquence de référence fournie par un oscillateur local ou par un synthétiseur, 110, est choisie égale à $F_{ol} = F_s - F_i$. Cette fréquence est une fréquence pure. Le comparateur de phase 90 compare la phase (ou la fréquence) du signal de sortie du filtre 70 avec la raie à fréquence pure à la fréquence $F_{ol}$. Ce comparateur de phase analogique génère une tension $u_l$ proportionnelle à la différence de phase instantanée entre ces deux fréquences. La tension $u_l$ représente donc, à une composante continue près, le signal audiofréquence démodulé. Le spectre de ce signal après filtrage dans le filtre de boucle 100 est donc un signal dans la bande audiofréquence. Ce signal est appliqué à l'entrée de modulation $e_1$ de l'oscillateur à la fréquence de sortie $F_s$, 10, cet oscillateur de sortie étant par ailleurs accordé en fréquence par l'intermédiaire d'une entrée $e_2$ qui permet de rattraper les dérives lentes dues au vieillissement ou à la température par exemple. L'oscillateur se trouve alors verrouillé en phase. La fréquence de référence pure $F_{ol}$ n'introduit par de perturbation ni de bruit de phase lorsqu'elle est produite par un synthétiseur ou un oscillateur à quartz. En conséquence toute variation de phase ou de fréquence à la sortie du modulateur à fréquence intermédiaire 50 se trouve transférée sans changement de caractéristique de bruit ou de linéarité à l'oscillateur de sortie 10.

Comme il a été indiqué ci-dessus, pour un oscillateur LC à commande de fréquence par varactors, le bruit augmente avec la fréquence. Le signal de sortie de l'oscillateur 10, bien que cet oscillateur ait une fréquence $F_s$ égale à 107 MHz par exemple, est débruité par la boucle à verrouillage de phase et son niveau de bruit devient égal au niveau de bruit de l'oscillateur à fréquence 10,7 MHz. Bien entendu il est nécessaire que le filtre de boucle 100 de la boucle à verrouillage de phase de l'oscillateur de sortie soit calculé de manière à ne pas introduire les défauts cités précédemment par variation d'amplitude ou de phase, tout en apportant un filtrage suffisant des perturbations hors bande. Pour satisfaire à cette condition le filtre 100 est un filtre à réjection de bande.

Cet émetteur présente, en plus du faible niveau de bruit (inférieur à 90 décibels au-dessous du niveau du signal utile), d'autres avantages:

le premier réside dans l'utilisation d'un modulateur à fréquence intermédiaire à fréquence fixe, ce modulateur pouvant être optimisé en ce qui concerne ses performances du fait que l'excursion de fréquence est indépendante de la fréquence d'émission du canal choisi;

le deuxième avantage est le choix de la fréquence d'émission du canal de sortie par simple changement de la fréquence de référence à l'entrée du comparateur de phase 90: Cette fréquence étant générée par un synthétiseur ou par un oscillateur à quartz, permet également de contribuer à une diminution du bruit de phase du signal de sortie.

De plus, comme indiqué ci-dessus le débruitage de l'oscillateur de sortie par la boucle linéaire à verrouillage de phase dans la bande d'asservissement et le filtrage des perturbateurs apparaissant en dehors de la bande d'asservissement de cette boucle, en particulier les harmoniques de la fréquence intermédiaire du modulateur ou les produits de battement en sortie du mélangeur à réjection 40, permettent également de contribuer à une bonne pureté spectrale de l'oscillateur de sortie.

Enfin, comme indiqué ci-dessus un amplificateur 120 est prévu en dérivation pour intégrer dans l'émetteur un contrôle des principales caractéristiques de l'émetteur, car le signal audiofréquence démodulé apparaît, aux corrections de boucle près, à l'entrée de l'oscillateur de sortie 10.

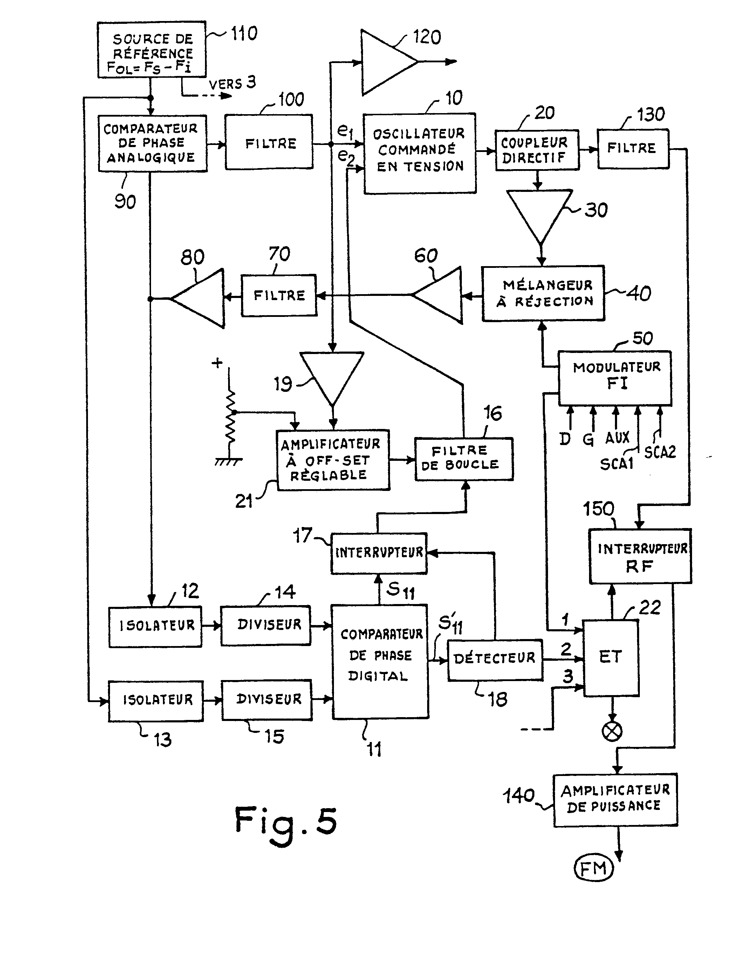

L'émetteur ainsi décrit peut être perfectionné. En effet, lors de la mise sous tension ou lors d'un changement de fréquence du canal de sortie, la boucle analogique qui permet la modulation de l'oscillateur de sortie se trouve déverrouillée, car sa plage de capture est faible (de l'ordre de 500 KHz) par rapport à la largeur totale de la bande FM (21 MHz). Le perfectionnement consiste donc à prévoir une boucle digitale de verrouillage de phase et de maintien en fréquence, pour la fréquence moyenne de l'oscillateur de sortie 10, reliée à l'entrée de commande $e_2$. La figure 5 représente un tel émetteur. Les mêmes éléments que sur la figure 1 ont été désignés par les mêmes repères.

Le rôle de la boucle digitale et du circuit de maintien prévus dans cet émetteur est de contrôler que la boucle analogique de verrouillage de phase de l'oscillateur de sortie 10 est bien dans sa plage de capture, d'obtenir un positionnement automatique en fréquence de l'oscillateur de sortie en cas de changement de fréquence, de maintenir le verrouillage de cette boucle analogique indépendamment des dérives possibles des caractéristiques des éléments par vieillissement ou variation de température, et enfin de réaliser un positionnement centré de la modulation par rapport à la plage de capture de la boucle de verrouillage de phase pour obtenir un maximum de dynamique du signal démodulé.

Cette boucle est constituée de la manière suivante: la sortie de la source de référence 110 et la sortie de l'amplificateur isolateur 80 situé dans la boucle de verrouillage de phase avant le comparateur de phase 90, sont respectivement reliées aux deux entrées d'un comparateur de phase digital 11, par l'intermédiaire d'isolateurs, respectivement 12 et 13, suivi de diviseurs, respectivement 14 et 15. Les diviseurs 14 et 15 sont des diviseurs rapides, de même taux, qui divisent la fréquence $F_{ol}$ fournie par l'oscillateur local et la fréquence du signal $F_s - F_i$ fourni par le filtre passe bande 70, pour les ramener aux environs de 500 KHz. Le comparateur de phase 11 (ou discriminateur de fréquence), fournit à sa sortie, $S_{11}$, un signal digital appliqué à l'entrée d'un filtre de boucle 16 par l'intermédiaire d'un interrupteur 17. Le filtre de boucle 16 intègre le signal à la sortie du comparateur de phase 11, et l'applique à l'entrée $e_2$ de commande de l'oscillateur de sortie 10. La tension de commande ainsi appliquée maintient la condition d'égalité de fréquence et d'écart de phase constant entre la fréquence de référence $F_{ol}$ et la fréquence $F_s - F_i$ à la sortie de l'amplificateur 80. Lorsque la condition d'égalité est vérifiée, le comparateur de phase fournit sur une sortie annexe $S'_{11}$ un signal logique de niveau 1 appliqué à l'entrée d'un détecteur 18 dit détecteur de verrouillage. Ce détecteur est un détecteur de crête dont la constante de temps est déterminée pour intégrer les impulsions résiduelles dues à un écart de phase non nul entre les deux fréquences présentes aux entrées du comparateur de phase 11; ce détecteur de verrouillage fournit un signal logique de niveau 0 appliqué à l'entrée de commande de l'interrupteur analogique 17. Ainsi, la détection de verrouillage provoque l'ouverture de l'interrupteur 17. Cette déconnexion de la boucle digitale est nécessaire en régime établi pour éviter une interaction de cette boucle digitale avec la boucle analogique qui créerait une instabilité du verrouillage de la boucle analogique. Pour maintenir la tension de commande à l'entrée $e_2$ à la valeur $u_2$ correspondant à la fréquence moyenne du canal de sortie au moment de la déconnexion de la boucle digitale, un circuit de maintien est prévu: ce circuit est constitué d'un amplificateur isolateur 19 dont l'entrée est reliée à la sortie du filtre 100, et dont la sortie est reliée à l'entrée d'un amplificateur opérationnel 21 à OFF-SET réglable. La sortie de cet amplificateur 21 est reliée à une seconde entrée du filtre de boucle 16. La valeur moyennee $u_1$ de la tension continue appliqué à l'entrée $e_1$ de l'oscillateur de sortie 10, est telle que après multiplication par le gain de la chaîne de maintien constituée par les amplificateurs 19, 21, le filtre de boucle génère la même tension $u_2$.

Le filtre de boucle 16 permet dans les deux cas, verrouillage et maintien, d'éliminer toute modulation audiofréquence pouvant apparaître à sa sortie pour ne conserver que la tension continue.

Ainsi, ce filtre permet d'éliminer une éventuelle "contre-modulation" qui serait créée dans l'oscillateur de sortie 10 par l'entrée de commande $e_2$. Le gain de cette chaîne de maintien, en continu, est très important, pratiquement égal à celui du filtre de boucle 16, et la tension continue moyenne, $u_1$ en sortie du comparateur de phase analogique 90 est maintenue à une valeur très faible. Toute dérive lente de l'oscillateur de sortie 10 est donc automatiquement compensée par ce circuit de maintien. La tension continue OFF-SET appliquée à l'amplificateur opérationnel 21 permet de centrer la modulation par modification de la tension continue $u_1$ en sortie du comparateur analogique de phase.

On a représenté sur cette figure le filtre de sortie 130 et l'étage amplificateur de puissance 140 reliés par un interrupteur du signal radiofréquence 150. Ainsi, il est possible d'empêcher l'émission du signal lorsque l'émission n'est pas effectuée dans des conditions normales. Pour cela, l'interrupteur radiofréquence 150 est commandé par le signal de sortie d'une porte ET 22. Cette porte ET reçoit sur trois entrées des informations caractéristiques du fonctionnement de l'émetteur. Sa première entrée 1 est reliée à une sortie du modulateur à fréquence intermédiaire 50 qui fournit un signal de niveau logique 1 lorsque la boucle de verrouillage du modulateur est effectivement verrouillée. Une seconde entrée 2 reçoit une information d'une sortie supplémentaire du détecteur de verrouillage 18, et une troisième entrée reçoit du synthétiseur de fréquence 110 une troisième information de verrouillage. Lorsque ces trois informations sont présentes, le niveau 1 apparaît à la sortie de la porte ET et commande la fermeture de l'interrupteur radiofréquence 150, à diodes PIN. Lorsque l'interrupteur est fermé, le signal modulé à la fréquence d'émission est appliqué aux étages de puissance 140 à la sortie de l'émetteur. Ces précautions évitent l'émission en dehors de la bande FM en cas de déverrouillage de l'une des boucles de l'émetteur. Un indicateur lumineux de verrouillage par exemple une diode émettrice de lumière, LED, peut être associée à la porte ET 22 pour indiquer l'état du système.

L'invention n'est pas limitée aux modes de réalisation précisément décrits et représentés. Des modifications de détails de l'émetteur, par exemple un choix différent de la fréquence de battement sélectionnée pour le verrouillage de la boucle analogique, ou des modifications dans la boucle digitale de verrouillage de la fréquence centrale $F_s$ ou dans le circuit de maintien, ne sortent pas du cadre de l'invention décrite ci-dessus.

## Revendications

1. Emetteur à modulation de fréquence comportant un oscillateur de sortie (10) centré sur la fréquence centrale $F_s$ du canal d'émission, ayant au moins une entrée de modulation de la fréquence d'émission, commandé par l'intermédiaire d'une boule à verrouillage de phase comportant en série, entre la sortie et l'entrée de modulation de l'oscillateur de sortie (10), un mélangeur (40) à réjection dont une première entrée est couplée à la sortie de l'oscillateur (10) et dont une seconde entrée est reliée à la sortie d'un modulateur recevant le signal de modulation; un filtre passe bande, un comparateur de phase analogique (90) dont une entrée est couplée à la sortie du filtre et dont l'autre entrée est couplée à un générateur de fréquence de référence $F_{o1}$ stable égale à la fréquence de battement entre la fréquence moyenne d'émission et la fréquence intermédiaire non atténuée, et un filtre passe bas (100) dont la sortie est couplée à l'entrée de modulation de l'oscillateur, est caractérisé en ce que, pour une radiodiffusion FM de grande qualité, le modulateur (50) est un modulateur en fréquence intermédiaire $F_i$, basse par rapport à la fréquence de l'oscillateur de sortie (10), comportant un oscillateur (51) commandé par une seconde boucle à verrouillage de phase (53, 54, 55, 56) et modulé par le signal de modulation.

2. Emetteur selon la revendication 1, caractérisé en ce que la fréquence de battement est celle du battement inférieur $F_s - F_i$.

3. Emetteur selon la revendication 2, caractérisé en ce que le mélangeur (40) est un mélangeur à réjection de la fréquence image de la fréquence du battement choisi.

4. Emetteur selon la revendication 3, caractérisé en ce que la seconde boucle de verrouillage de phase (53 à 56) comporte un oscillateur de référence à quartz, pour maintenir stable la fréquence intermédiaire moyenne.

5. Emetteur selon la revendication 1, caractérisé en ce que l'oscillateur de sortie (10) comporte une entrée de commande pour compenser l'effet des dérives sur sa fréquence centrale d'émission, cette entrée étant commandée lors de la mise sous tension et lors d'un changement de fréquence d'émission par un boucle digitale de verrouillage de phase comportant un comparateur de phase digital (11) dont les entrées sont reliées aux deux entrées du comparateur de phase analogique (90) par l'intermédiaire de diviseurs de fréquence (14, 15), la sortie de ce comparateur étant couplée à l'entrée de commande de l'oscillateur de sortie (10) par l'intermédiaire d'un interrupteur (17) et d'un filtre passe bas (16), et en ce que cette entrée est commandée en régime établi par un circuit de maintien comportant un amplificateur (21) à tension d'OFF-SET réglable dont la sortie est également reliée à l'entrée du filtre passe bas (16), le gain de cette boucle permettant de maintenir la tension de commande appliquée à l'entrée de commande de l'oscillateur de sortie (10), un détecteur de verrouillage relié à la sortie du comparateur de phase digital (11) commandant l'interrupteur (17).

6. Emetteur selon la revendication 5, caractérisé en ce que le détecteur de verrouillage est également relié à l'entrée de commande d'un interrupteur (150) placé dans la voie de sortie de l'émetteur pour interrompre toute émission tant que l'émetteur n'est pas verrouillé sur la fréquence d'émission.

7. Emetteur selon la revendication 6, caractérisé en ce que chacune des boucles de verrouillage a une sortie de contrôle reliée à l'entrée d'une porte ET (22) dont la sortie commande l'interrupteur (150) placé dans la voie de sortie de l'émetteur.

## Patentansprüche

1. Mit Frequenzmodulation arbeitender Sender, mit einem Ausgangs-Oszillator (10), der auf die Mittenfrequenz $F_s$ des Sendekanals zentriert ist und wenigstens einen Eingang zum Modulieren der Sendefrequenz aufweist sowie durch eine Phasen-Verriegelungsschleife gesteuert ist, die zwischen dem Modulationsausgang und dem Modulationseingang des Ausgangs-Oszillators (10) in Reihe geschaltet einen selektiven Mischer (40), wovon ein erster Eingang an den Ausgang des Oszillators (10) angekoppelt ist und ein zweiter Ausgang mit dem Ausgang eines das Modulationssignal empfangenden Modulators verbunden ist, ein Bandpaß-Filter, einen analogen Phasendetektor (90), wovon ein Eingang an den Ausgang des Filters angekoppelt ist und wovon der andere Ausgang an einen Generator zum Erzeugen einer stabilen Referenzfrequenz $F_{ol}$ angekoppelt ist, die gleich der Schwegungsfrequenz zwischen der mittleren Sendefrequenz und der ungedämpften Zwischenfrequenz ist, und ein Tiefpaß-Filter (100) umfaßt, dessen Ausgang an den Eingang zum Modulieren des Oszillators angekoppelt ist, dadurch gekennzeichnet, daß für eine hochwertige FM-Rundfunkübertragung der Modulator (50) ein Modulator für die Zwischenfrequenz $F_1$ ist, die im Verhältnis zu der Frequenz des Ausgangs-Oszillators (10) niedrig ist, mit einem über eine zweite Phasen-Verriegelungsschleife (53, 54, 55, 56) gesteuerten und durch das Modulationssignal modulierten Oszillator (51).

2. Sender nach Anspruch 1, dadurch gekennzeichnet, daß die Schwebungsfrequenz diejenige der niedrigeren Schwebung $F_s - F_i$ ist.

3. Sender nach Anspruch 2, dadurch gekennzeichnet, daß der Mischer (40) ein Mischer ist, der die Bildfrequenz der Frequenz der gewählten Schwebung unterdrückt.

4. Sender nach Anspruch 3, dadurch gekennzeichnet, daß die zweite Phasen-Verriegelungsschleife (53 bis 56) einen Quarz-Referenzoszillator umfaßt, um die mittlere Zwischenfrequenz stabil zu halten.

5. Sender nach Anspruch 1, dadurch gekennzeichnet, daß der Ausgangs-Oszillator (10) einen Steuereingang umfaßt, um die Auswirkung der Abdriften auf seine mittlere Sendefrequenz auszugleichen, wobei dieser Eingang bei dem Unterspannungsetzen und bei einer Veränderung der Sendefrequenz angesteuert wird durch eine digitale Phasen-Verriegelungsschleife, welche einen digitalen Phasen-Vergleicher (11) umfaßt, dessen Eingänge mit den beiden Eingängen des analogen Phasen-Vergleichers (90) über Frequenzteiler (14, 15) verbunden sind, wobei der Ausgang dieses Vergleichers mit dem Eingang zur Steuerung des Ausgangs-Oszillators (10) über einen Unterbrecher (17) und ein Tiefpaß-Filter (16) verbunden ist, und daß dieser Eingang im eingeschwungenen Zustand über eine Aufrechterhaltungsschaltung gesteuert ist, die einen eine einstellbare Offset-Spannung aufweisenden Verstärker (21) umfaßt, wovon der Ausgang ebenfalls mit dem Eingang des Tiefpaß-Filters (16) verbunden ist, wobei die Verstärkung dieser Schleife die Aufrechterhaltung der Steuerspannung ermöglicht, welche an den Steuereingang des Ausgangs-Oszillators (10) angelegt wird, und wobei ein Verriegelungs-Detektor, der mit dem Ausgang des digitalen Phasen-Vergleichers (11) verbunden ist, den Unterbrecher (17) steuert.

6. Sender nach Anspruch 5, dadurch gekennzeichnet, daß der Verriegelungs-Detektor ferner mit dem Eingang zur Steuerung eines Unterbrechers (150) verbunden ist, der in den Ausgangsweg des Senders eingefügt ist, um jegliche Aussendung zu unterbrechen, solange der Sender nicht auf der Sendefrequenz verriegelt ist.

7. Sender nach Anspruch 6, dadurch gekennzeichnet, daß jede der Verriegelungsschleifen einen Steuerausgang aufweist, der mit dem Eingang einer AND-Schaltung (22) verbunden ist, deren Ausgang den in den Ausgangsweg des Senders eingefügten Unterbrecher (150) steuert.

## Claims

1. An FM transmitter comprising an output oscillator (10) centered on the central frequency $F_s$ of the transmission channel, having at least one modulation input of the transmission frequency, controlled by means of a PLL comprising in series, between the output and the input of modulation of the output oscillator (10), a rejecting mixer (40) of which a first input is coupled with the output of the oscillator (10) and of which a second input is connected with the output of a modulator receiving the modulation signal, a pass band filter, an analog phase comparator (90) whose one input is coupled with the output of the filter and whose other input is coupled with a generator providing a stable reference frequency $F_{ol}$ equal to the beat frequency between the mean transmission frequency and the non-attenuated intermediate frequency, and a low pass filter (100) whose output is coupled with the modulation input of the oscillator, characterized in that for high quality FM broadcasting the modulator (50) is a modulator with an intermediate frequency $F_i$, low in relation to the frequency of the output oscillator (10), comprising an oscillator (51) controlled by a second PLL (53, 54, 55 and 56) and modulated by the modulation signal.

2. The transmitter as claimed in claim 1, characterized in that the beat frequency is that of the lower beat $F_s - F_i$.

3. The transmitter as claimed in claim 2, characterized in that the mixer (40) is a mixer for the rejection of the image frequency of the selected beat frequency.

4. The transmitter as claimed in claim 3, characterized in that the second PLL (53 through 56) comprises a quartz reference oscillator in order to keep the intermediate mean frequency stable.

5. The transmitter as claimed in claim 1, characterized in that the output oscillator (10) comprises a control input in order to compensate for the effect of drift on its central transmission frequency, said input being controlled at the time of application of power and at the time of a change in frequency of transmission by a digital PLL comprising a digital phase comparator (11) whose inputs are connected with two inputs of the analog phase comparator (90) by way of frequency dividers (14 and 15), the output of this comparator being coupled with the control input of the output oscillator (10) by way of a switch (17) and of a low pass filter (16), and in that this input is controlled by a system estabilished by a hold circuit comprising an amplifier (21) with an adjustable offset voltage whose output is also connected with the input of the low pass filter (16), the gain of this loop making it possible to maintain the control voltage applied to the control input of the output oscillator (10), a locking detector connected with the output of the digital phase comparator (11) operating the switch (17).

6. The transmitter as claimed in claim 5, characterized in that the locking detector is also connected with the control input of a switch (150) placed in the output path of the transmitter in order to interrupt all transmission as long as the transmitter is not locked on the transmission frequency.

7. The transmitter as claimed in claim 6, characterized in that each of the locked loops has a control output connected with the input of an AND gate (22) whose output operates the switch (150) placed in the output path of the transmitter.

Fig.1

Fig.2

Fig.3

Fig.4

2

Fig.5